**Europäisches Patentamt**

**European Patent Office**

**Office européen des brevets**

(19)

(11) Veröffentlichungsnummer: **0 021 429**
**A2**

(12) # EUROPÄISCHE PATENTANMELDUNG

(21) Anmeldenummer: **80103611.2**

(22) Anmeldetag: **26.06.80**

(51) Int. Cl.³: **G 03 C 1/68**
// G03F7/10, G03F7/26

(30) Priorität: **29.06.79 DE 2926235**

(43) Veröffentlichungstag der Anmeldung: **07.01.81**
**Patentblatt 81/1**

(84) Benannte Vertragsstaaten: **AT BE CH DE FR GB IT LI NL SE**

(71) Anmelder: **HOECHST AKTIENGESELLSCHAFT, KALLE Niederlassung der Hoechst AG Patentabteilung Postfach 3540, Rheingaustrasse 190 D-6200 Wiesbaden 1 (DE)**

(72) Erfinder: **Horn, Klaus, Dr., Lessingstrasse 53, D-6238 Hofheim/Ts. (DE)**
Erfinder: **Klüpfel, Kurt Dr., Dreispitzstrasse 2a, D-6200 Wiesbaden-Sonnenberg (DE)**
Erfinder: **Steppan, Hartmut, Dr., Panoramastrasse 17, D-6200 Wiesbaden-Dotzheim (DE)**

(54) **Photopolymerisierbares Kopiermaterial und Verfahren zur Herstellung von Reliefbildern.**

(57) Es wird ein photopolymerisierbares Kopiermaterial, insbesondere für die Herstellung von Druckformen beschrieben, das keine sauerstoffhemmende Deckschicht aufweist und dessen photopolymerisierbare Schicht eine polymerisierbare Verbindung, einen Photoinitiator, ein polymeres Bindemittel und ein feinteiliges Pigment enthält, dessen mittlere Teilchengröße mindestens der Schichtdicke der Kopierschicht entspricht. Das Material zeigt beim Kontaktkopieren im Vakuumkopierrahmen keine auf Sauerstoffhemmung zurückzuführende ungleichmäßige Belichtungswirkung.

EP 0 021 429 A2

0021429

Photopolymerisierbares Kopiermaterial und Verfahren
zur Herstellung von Reliefbildern

Die Erfindung betrifft ein photopolymerisierbares Kopiermaterial, dessen photopolymerisierbare Schicht ein polymeres Bindemittel, eine polymerisierbare Verbindung und
einen Photoinitiator enthält, sowie ein Verfahren zur Herstellung von Reliefbildern, insbesondere Druckformen und
Photoresists, unter Verwendung dieses Materials.

Photopolymerisierbare Materialien der angegebenen Gattung
sind bekannt. Bei ihrer Verarbeitung ist es notwendig, den
Einfluß des Luftsauerstoffs auf die radikalische Polymerisation auszuschalten oder so weit wie möglich zu unterdrücken. Das erfolgt zumeist dadurch, daß man die photopolymerisierbare Schicht mit einem abziehbaren sauerstoffundurchlässigen Deckblatt (US-PS 3 060 026) oder mit einer
sauerstoffundurchlässigen Deckschicht abdeckt, die in dem
Entwickler löslich ist (US-PS 3 458 311). Hierdurch wird
verhindert, daß während der lichtinduzierten Polymerisation
Sauerstoff in die Schicht eindiffundiert und dort zu Kettenabbruchreaktionen führt, die sich in einer unvollständigen
Polymerisation und damit geringeren Lichtempfindlichkeit auswirken.

Der Nachteil der bekannten Materialien liegt in dem zusätzlichen Arbeitsschritt, der für das Aufbringen von Deckfolie
oder Deckschicht erforderlich ist. Weiterhin wird die Bildauflösung bei Verwendung selbsttragender Deckfolien, die in

HOECHST   AKTIENGESELLSCHAFT
KALLE  Niederlassung der Hoechst AG

- 2 -

der Regel eine Dicke um 20 µm haben, beim Kontaktkopieren verschlechtert. Deckschichten, die im Entwickler löslich sind, haben einen rascheren Verbrauch desselben und eine zusätzliche Abwasserbelastung zur Folge. Man hat deshalb versucht, photopolymerisierbare Materialien herzustellen, die auch ohne Deckschicht eine ausreichende Lichtempfindlichkeit bei der bildmäßigen Polymerisation zeigen.

In der DE-OS 28 30 143 wird ein derartiges Material beschrieben, das bestimmte polymerisierbare Verbindungen mit höherem Molekulargewicht und bestimmte Initiatorsysteme enthält und daher eine geringere Sauerstoffempfindlichkeit aufweist. Die photopolymerisierbare Schicht dieses Materials kann, ebenso wie die von anderen bekannten Materialien dieser Gattung, Füllstoffe oder Pigmente enthalten, die im aktinischen Bereich transparent sind, z. B. Siliciumdioxide, Bentonite, Glaspulver, Farbpigmente oder kolloidaler Kohlenstoff. Diese Zusätze bewirken eine Erhöhung der Festigkeit und Verringerung der Klebrigkeit oder dienen zur Anfärbung der Schicht. Von einem Einfluß auf die Oberflächenstruktur der Schicht oder deren Empfindlichkeit bei der Belichtung wird nichts gesagt.

Es hat sich nun gezeigt, daß es bei der üblichen Belichtung derartiger Materialien, d. h. beim Kontaktkopieren im Vakuumrahmen, nach der Entwicklung zu fleckigen Kopien und zu Störungen bei der Anwendung, z. B. als Flachdruckformen, kommt. Diese Erscheinung tritt um so stärker auf, je glatter die Kopierschicht ist.

Es wird vermutet, daß diese Störung ihre Ursache darin hat, daß die Kopierschicht bei Anwesenheit und bei Abwesenheit von Luft eine etwas unterschiedliche Empfindlichkeit aufweist. Wenn die Vorlage im Vakuumrahmen in engen Kontakt mit der Kopierschicht gebracht wird, können Stellen mit festerer und weniger fester Berührung, gegebenenfalls durch Ausbildung von kleineren Lufteinschlüssen entstehen. Hierdurch wird die Schicht örtlich teils über-, teils unterbelichtet, und es ergibt sich eine fleckige Kopie.

Aufgabe der Erfindung war es, ein photopolymerisierbares Kopiermaterial vorzuschlagen, das ohne sauerstoffhemmende Deckschicht verarbeitet werden kann und das beim Kontaktkopieren im Vakuumrahmen keine Wirkungen ungleichmäßiger Belichtung bzw. Polymerisation zeigt.

Die Erfindung geht aus von einem photopolymerisierbaren Kopiermaterial mit einem Schichtträger und einer photopolymerisierbaren Kopierschicht mit freiliegender Oberfläche, die ein polymeres Bindemittel, eine Verbindung mit mindestens zwei endständigen, äthylenisch ungesättigten radikalisch polymerisierbaren Gruppen, einen Photoinitiator zur Einleitung der radikalischen Polymerisation und ein feinteiliges Pigment enthält.

Das erfindungsgemäße Kopiermaterial ist dadurch gekennzeichnet, daß die mittlere Teilchengröße des Pigments mindestens der Schichtdicke der Kopierschicht entspricht.

0021429

Die Schichtdicke der Kopierschicht liegt bevorzugt im
Bereich von 0,5 bis 12 µm.

Die mittlere Teilchengröße des Pigments beträgt im allgemeinen 2 bis 30 µm.

Der Gehalt der Kopierschicht, bezogen auf ihre nichtflüchtigen Bestandteile, an feinteiligem Pigment beträgt
im allgemeinen 0,05 bis 5, vorzugsweise 0,1 bis 2 Gew.-%.

Als Pigmente werden vorzugsweise anorganische Pigmente
verwendet, insbesondere bei der Verwendung des Materials
zur Herstellung von Druckformen. Es werden ferner farblose Pigmente bevorzugt, da diese die Lichtabsorption
der Schicht und damit die Lichtempfindlichkeit nicht
beeinflussen. Es ist zwar grundsätzlich möglich, der
Schicht auch Farbpigmente zuzusetzen, um einen visuellen
Bildkontrast zu erzielen, doch ist es hierbei vorzuziehen,
wenn man Menge und spezifische Absorption des Pigments frei
wählen und auf die konkret vorliegende Schichtzusammensetzung abstimmen kann. Es ist daher nicht zweckmäßig,
den gleichen Zusatz für die Lösung beider Aufgaben zu
verwenden.

Als Partikel, die gemäß der Erfindung in die lichtempfindliche Kopierschicht eingelagert werden, können im übrigen
solche Substanzen verwendet werden, die mit der Kopierschicht verträglich sind, die Beschichtung des Trägers
nicht nachteilig beeinflussen und zusammen mit den unbelichteten Bereichen der photopolymerisierbaren Schicht mit Hilfe eines Entwicklers wieder entfernt werden können, ohne mit diesem zu reagieren.

Bevorzugte Beispiele für derartige Partikel sind Teilchen aus Kieselsäure oder Siliciumdioxid, die speziell vorbehandelt sein können, aus Aluminiumoxid, Aluminiumsilikat, Aluminiumhydroxid, Titandioxid oder in den zur Beschichtung verwendeten Lösungsmitteln unlöslichen organischen polymeren Verbindungen. Die Partikel können jeweils aus einer Substanz bestehen, oder es können Partikel aus verschiedenen Substanzen kombiniert werden.

Zur Herstellung der Kopierschichten werden die Teilchen unter gutem Rühren direkt zur Beschichtungslösung gegeben oder vorteilhafter in einer Kugelmühle zusammen mit einem Teil des Harzes oder Binders, der ohnehin für die Kopierschicht verwendet wird, in einem geeigneten Lösungsmittel dispergiert. Diese Dispersion wird dann dem Rest der vorgesehenen Beschichtungslösung unter gutem Rühren zugefügt.

Die Kopierschicht des erfindungsgemäßen Kopiermaterials besteht im wesentlichen aus Monomeren, Photoinitiatoren, Bindemitteln und den beschriebenen Pigmenten; sie kann jedoch noch eine Reihe weiterer Zusätze enthalten, z. B.

> Stabilisatoren bzw. Inhibitoren zur Verhinderung der thermischen Polymerisation der Kopierschicht,
> Wasserstoffdonatoren, Weichmacher,
sensitometrische Regler und
Farbstoffe oder Farbpigmente.

Als Photoinitiatoren eignen sich eine Vielzahl von Substanzen, beispielsweise Benzoin, Benzoinäther, Mehrkernchinone, z. B. 2-Äthyl-anthrachinon; Acridinderivate, z. B. 9-Phenyl-acridin, 9-p-Methoxyphenyl-acridin, 9-Acetylamino-acridin, Benz(a)acridin; Phenazinderivate, z. B. 9,10-Dimethyl-benz(a)phenazin, 9-Methyl-benz(a)-phenazin, 10-Methoxy-benz(a)phenazin; Chinoxalinderivate, z. B. 6,4',4"-Trimethoxy-2,3-diphenyl-chinoxalin, 4',4"-Dimethoxy-2,3-diphenyl-5-aza-chinoxalin; Chinazolinderivate; synergistische Mischungen verschiedener Ketone; Farbstoff/Redoxsysteme; Thiopyryliumsalze und dgl. mehr.

Für die Zwecke der Erfindung geeignete photopolymerisierbare Monomere sind bekannt und z. B. in den USA-Patentschriften 2 760 863 und 3 060 023 beschrieben.

Bevorzugte Beispiele sind Acryl- und Methacrylsäureester, wie Diglycerindiacrylat, Polyäthylenglykoldimethacrylat, Acrylate und Methacrylate von Trimethyloläthan, Trimethylolpropan und Pentaerytnrit und von mehrwertigen alicyclischen Alkoholen. Mit Vorteil werden auch Umsetzungsprodukte von Diisocyanaten mit Partialestern mehrwertiger Alkohole eingesetzt. Derartige Monomere sind in den DE-OS 2 064 079 und DE-OS 23 61 041 beschrieben.

Als Wasserstoffdonatoren werden in der Hauptsache aliphatische Polyäther verwendet. Gegebenenfalls kann diese Funktion auch vom Bindemittel oder von dem polymerisierbaren Monomeren übernommen werden, wenn diese labile Wasserstoffatome besitzen.

Als Bindemittel können eine Vielzahl löslicher organischer Polymerisate Einsatz finden. Als Beispiele seien genannt: Polyamide, Polyvinylester, Polyvinylacetale, Polyvinyläther, Polyacrylsäureester, Polymethacrylsäureester, Polyester, Alkydharze, Polyacrylamid, Polyvinylalkohol, Polyäthylenoxid, Polydimethylacrylamid, Polyvinylpyrrolidon, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine, Celluloseäther und dgl.

Mit besonderem Vorteil werden Bindemittel verwendet, die in wäßrig-alkalischen Lösungen löslich oder mindestens quellbar sind, da sich Schichten mit solchen Bindemitteln mit den bevorzugten wäßrig-alkalischen Entwicklern entwickeln lassen. Derartige Bindemittel können z. B. die folgenden Gruppen enthalten: -COOH, -PO$_3$H$_2$, -SO$_3$H, -SO$_2$NH$_2$, -SO$_2$-NH-CO- und dgl.. Als Beispiele hierfür seien genannt: Maleinatharze, Polymerisate aus N-(p-Tolylsulfonyl)-carbaminsäure-(ß-methacryloyloxy-äthyl)-ester

0021429

- 8 -

und Mischpolymerisate dieser und ähnlicher Monomerer mit anderen Monomeren und Styrol-Maleinsäureanhydrid-Misch- polymerisate. Methylmethacrylat-Methacrylsäure-Mischpoly- merisate und Mischpolymerisate aus Methacrylsäure, Alkylmethacrylaten und Methylmethacrylat und/oder Styrol, Acrylnitril u. a., wie sie in den DE-OS 2 064 080 und 2 363 806 beschrieben sind, werden bevorzugt.

Die Auswahl der geeigneten Träger erfolgt nach Maßgabe der Art der Druckplatte. Im allgemeinen wird Aluminium verwendet, das bevorzugt eine anodisch erzeugte poröse Oxidschicht trägt. Das Aluminium wird zweckmäßig vor dem Anodisieren mechanisch, chemisch oder elektrolytisch aufgerauht. Die Anodisierung erfolgt in bekannter Weise, z. B. in Schwefel- und/oder Phosphorsäure, vorzugsweise unter solchen Bedingungen, daß eine Oxidschicht mit einem Schichtgewicht von etwa 0,5 bis 10 g/m² erhalten wird.

Vorteilhaft wird die Oxidschicht vor dem Aufbringen der lichtempfindlichen Schicht einer Vorbehandlung zur Verbesserung des drucktechnischen Verhaltens, insbesondere der Hydrophilie, unterworfen, z. B. mit Silikaten oder Polyvinylphosphonsäure. Die Beschichtung des Trägermaterials erfolgt in bekannter Weise durch Aufschleudern, Sprühen, Tauchen, mittels Walzen, Schlitzdüsen, Rakeln oder durch Gießer-Antrag.

Es ist vorteilhaft, die Streichlösung während des Beschichtungsvorganges durch ständiges Rühren in Bewegung zu halten. Ferner können der Streichlösung zwecks besserer Benetzung gegebenenfalls Netz- oder Verlaufmittel zugesetzt werden.

Zur Entwicklung wird die belichtete Druckplatte mit einer
geeigneten Entwicklerlösung, bevorzugt einer schwach
alkalischen wäßrigen Lösung behandelt, wobei die unbelichteten Anteile der Schicht entfernt werden und die belichteten Bereiche der Kopierschicht einschließlich der in der
Schicht enthaltenen Pigmente auf dem Träger zurückbleiben.

Das erfindungsgemäße photopolymerisierbare Kopiermaterial
wird im Kontakt mit einer Transparentvorlage in üblicher
Weise im Vakuumkopierrahmen belichtet. Dabei stellt sich
ein enger und zugleich gleichmäßiger Kontakt zwischen
Vorlage und photopolymerisierbarer Kopierschicht ein,
der eine völlig gleichmäßige Belichtung entsprechend dem
Bild der Vorlage über die gesamte Bildfläche bewirkt. Es
wird angenommen, daß durch die Rauhigkeit der Schicht,
die durch die aus ihr herausragenden Pigmentpartikel
hervorgerufen wird, die Ausbildung von lokalen Lufteinschlüssen und damit eine örtlich unterschiedliche
Hemmung der Polymerisation vermieden wird. Es ist möglich, daß die gleichmäßige Abbildung der Vorlage zusätzlich durch den überall gleichmäßigen Abstand zwischen
Kopierschicht und Vorlage und die dadurch verhinderte
Ausbildung örtlicher Unterstrahlungen begünstigt wird.

Das erfindungsgemäße Kopiermaterial wird, wie bereits
erwähnt, vorzugsweise zur Herstellung von Flachdruckformen verwendet. Es ist jedoch grundsätzlich für alle
Anwendungen geeignet, bei denen Kontaktkopien in einem
Vakuumkopierrahmen gemacht werden und bei denen es auf
hohe Bildauflösung und getreue Wiedergabe der Vorlage
ankommt. Weitere Anwendungsformen sind deshalb die Herstellung von Ätzdruckformen, z. B. Mehrmetall- und Tiefdruckformen, sowie von Photoresists als Ätz- oder
Galvanoreservagen, z. B. bei der Herstellung gedruckter
Schaltungen.

Die Erfindung wird an Hand der nachfolgenden Beispiele
näher erläutert, in denen Gewichtsteile (Gt) und Volumteile (Vt) im Verhältnis von g zu ccm stehen. Prozente
sind, wenn nichts anderes angegeben ist, Gewichtsprozente.
Die Dichte der trockenen photopolymerisierbaren Schichten
liegt bei einem Wert um 1,1 g/cm³.

Beispiel 1
Als Schichtträger für Druckplatten wird elektrochemisch
aufgerauhtes und anodisiertes Aluminium mit einer Oxidschicht von 3 g/m² verwendet, das mit einer Lösung folgender Zusammensetzung überzogen wird:

| | |
|---|---|
| 11,7 Gt | einer 33,4%igen Lösung eines Methyl-methacrylat/Methacrylsäure-Mischpoly-merisats mit der Säurezahl 110 und dem mittleren Mol-Gewicht 35.000 in Methyläthylketon, |
| 3,9 Gt | Trimethyloläthantriacrylat, |
| 0,07 Gt | 9-Phenyl-acridin, |
| 0,07 Gt | 4-Dimethylamino-4'-methyl-dibenzalaceton, |
| 0,04 Gt | eines Azofarbstoffs aus 2,4-Dinitro-6-chlor-benzoldiazoniumsalz und 2-Methoxy-5-acetylamino-N-cyanäthyl-N-hydroxyäthyl-anilin, |

0,07 Gt amorphe hochporöse Kieselsäure,
mittlere Teilchengröße 8 µm,

38,0 Gt Äthylenglykolmonoäthyläther,

13,5 Gt Butylacetat.

Das Auftragen erfolgt durch Aufschleudern in der Weise, daß ein Trockengewicht von 2,8 - 3 g/m² erhalten wird. Anschliessend wird die Platte 2 Minuten bei 100°C im Umlufttrockenschrank getrocknet.

Proben der erhaltenen Druckplatte werden mittels einer 5 kW-Metallhalogenidlampe unter einem 13stufigen Belichtungskeil mit Dichte-inkrementen von 0,15 jeweils 10, 20, 40 und 80 Sekunden belichtet.

Anschließend werden die Platten mit einem Entwickler folgender Zusammensetzung entwickelt:

120 Gt Natriummetasilikat $\cdot$ 9 $H_2O$,

2,13 Gt Strontiumchlorid,

1,2 Gt nichtionogenes Netzmittel(Kokosfettalkohol-Polyoxyäthylenäther mit ca. 8 Oxyäthyleneinheiten),

0,12 Gt Antischaummittel, 4000 Gt vollentsalztes Wasser.

Die Platten werden mit 1%iger Phosphorsäure sauer gestellt und mit fetter Druckfarbe eingefärbt. Man erhält die folgenden vollvernetzten Keilstufen:

vollvernetzte Keilstufen bei

| 10 | 20 | 40 | 80 Sekunden |
|----|----|----|-------------|
|    | 1  | 2  | 4           |

Beispiel 2

Auf eine elektrochemisch aufgerauhte und anodisierte Aluminiumoberfläche mit einer Oxidschicht von 3 g/m² wird eine Lösung folgender Zusammensetzung so aufgeschleudert, daß ein Schichtgewicht von 3,5 g/m² erhalten wird:

10,0 Gt einer 20%igen Lösung eines Terpolymerisates aus Styrol, n-Hexylmethacrylat und Methacrylsäure (10 : 60 : 30) mit der Säurezahl 190 in Butanon,

2,0 Gt des Umsetzungsproduktes aus 1 Mol 2,2,4-Trimethyl-hexamethylendiisocyanat und 2 Mol 2-Hydroxy-äthylmethacrylat,

0,3 Gt 9-Phenyl-acridin,

0,15 Gt 4-Chlor-benzalchinaldin,

0,03 Gt Methylviolett (C.I. 42 535),

18,0 Gt Butanon,

7,5 Gt Butylacetat,

0,06 Gt hochreines Siliciumdioxid, mittlere Teilchengröße 3 µm.

Die beschichtete Platte wird anschließend 2 Minuten bei 100°C im Umlufttrockenschrank getrocknet.

Man belichtet nun die Platte 40 Sekunden unter einem 13stufigen Belichtungskeil und entwickelt mit einem Entwickler folgender Zusammensetzung:

5,3 Gt Natrium-metasilikat · 9 $H_2O$,
3,4 Gt tert. Natriumphosphat · 12 $H_2O$,
0,3 Gt sec. Natriumphosphat · 12 $H_2O$,
91,0 Gt vollentsalztes Wasser.

Die Platte wird mit 1%iger Phosphorsäure sauer gestellt und mit fetter Druckfarbe eingefärbt.

Beispiel 3

Auf eine elektrochemisch aufgerauhte, anodisierte Aluminiumoberfläche mit einer Oxidschicht von 3 g/m² wird eine Lösung folgender Zusammensetzung so aufgeschleudert, daß ein Schichtgewicht von 3 g/m² erhalten wird:

11,4 Gt der in Beispiel 1 angegebenen Mischpolymerisatlösung,
37,9 Gt Äthylenglykolmonoäthyläther,
13,45 Gt Butylacetat,
4,0 Gt Trimethyloläthantriacrylat,
0,07 Gt 4-Methyl-benzalchinaldin,
0,04 Gt des in Beispiel 1 angegebenen Azofarbstoffs,
0,07 Gt 4-Dimethylamino-4'-methyl-dibenzalaceton,
0,056 Gt Aluminiumoxid, mittlere Teilchengröße 5 μm.

Die erhaltene Offsetdruckplatte wird mittels einer
Metallhalogenidlampe von 5 kW 40 Sekunden unter einem
13stufigen Belichtungskeil mit Dichteinkrementen von
0,15 belichtet.

Anschließend wird die Platte mit dem in Beispiel 1 beschriebenen Entwickler entwickelt.

Sie wird dann mit 1%iger Phosphorsäure sauer gestellt und
mit fetter Druckfarbe eingefärbt.

Beispiel 4
Eine Lösung zur Beschichtung eines elektrochemisch aufgerauhten und anodisierten Aluminiumträgers mit einer
Oxidschicht von 3 g/m² wird wie folgt angesetzt:

| | |
|---|---|
| 5,7 | Gt einer 35%igen Lösung des in Beispiel 1 angegebenen Mischpolymerisats in Methyl-äthylketon, |
| 3,0 | Gt des Additionsprodukts aus 2 Mol Acryl-säure und 1 Mol des Bisglycidäthers des Bisphenols A (Br-Zahl 66; OH-Zahl 231), |
| 0,125 | Gt 9-Phenyl-acridin, |
| 0,07 | Gt des in Beispiel 1 angegebenen Azofarbstoffs, |
| 24,0 | Gt Methyläthylketon, |
| 12,0 | Gt Butylacetat. |

HOECHST AKTIENGESELLSCHAFT
KALLE Niederlassung der Hoechst AG

- 15 -

Anschließend wird die Lösung filtriert und mit 0,04 Gt einer amorphen Kieselsäure mit einem
mittleren Teilchendurchmesser von
4 µm versetzt und eine halbe Stunde
intensiv gerührt.

Die Beschichtung der Aluminiumfolie erfolgt in der Weise,
daß nach Aufgießen oder Aufschleudern der Lösung und
Trocknung bei ca. 40°C ein Schichtgewicht von ca. 3 g/m²
erhalten wird.

Die beschichtete Platte wird noch 2 Minuten bei 100°C in
einem Umlufttrockenschrank nachgetrocknet.

Mit einer 5 kW Metallhalogenid-Lampe wird die beschichtete
Platte 40 Sekunden unter einer Negativ-Filmvorlage belichtet und mit einem Entwickler folgender Zusammensetzung
entwickelt:

7,2 Gt Natrium-metasilikat · 9 $H_2O$,
0,023 Gt des in Beispiel 1 angegebenen nichtionogenen
Netzmittels,
0,01 Gt Antischaummittel,
92,67 Gt vollentsalztes Wasser.

Die Platte wird mit 1%iger Phosphorsäure sauer gestellt und
mit fetter Druckfarbe eingefärbt.

Auf einer Offsetdruckmaschine wurde eine Druckauflage
von 100.000 erreicht.

Beispiel 5

Eine Lösung, wie in Beispiel 2 beschrieben, die aber
statt des dort angegebenen Kieselsäurepigments 0,06 Gt
der in Beispiel 1 angegebenen Kieselsäure enthält,
wird auf einen gereinigten Träger, der aus einem
Isolierstoffmaterial mit 35 µm Kupferauflage besteht,
so aufgeschleudert, daß man eine Schichtdicke von ca.
5 µm erhält. Die Schicht wird 5 Minuten bei 100°C im
Umlufttrockenschrank nachgetrocknet. Der Beschichtungs-
und Trocknungsvorgang kann auch beidseitig durchgeführt
werden.

Anschließend werden Proben des Materials mittels einer
5 kW MH-Lampe mit 140 cm Abstand unter einem Stufenkeil,
wie in Beispiel 1 beschrieben, 2, 4, 8, 16, 32 und 64
Sekunden belichtet und die Platten mit 0,8%iger Sodalösung in einem Sprühgerät 30 bis 60 Sekunden entwickelt.

Man erhält, entsprechend der Belichtungszeit, folgende
vollvernetzte Keilstufen. In Klammern ist gegebenenfalls die Anzahl einschließlich der nahezu vollständig
vernetzten Stufen angegeben.

| Belichtungszeit | Vollvernetzte Keilstufen |
|---|---|
| 2 Sekunden | 3 |
| 4 " | 4 |
| 8 " | 5 (6) |
| 16 " | 7 (8) |
| 32 " | 9 |
| 64 " | 10 (11) |

Die vernetzten Bereiche sind gegen die in der Leiterplattentechnik übliche Eisen-III-chlorid-Ätzlösung resistent. Der Unterätzfaktor liegt unter 10 % der Linienbreite.

Bei einer Wiederholung des Beispiels mit einer photopolymerisierbaren Schicht, die kein Kieselsäurepigment enthielt, wurden zwar Lichtempfindlichkeiten in der gleichen Größenordnung gefunden, die Ergebnisse ließen sich aber bei gleichen Belichtungszeiten nicht zuverlässig reproduzieren. Die Oberfläche der Schicht war an belichteten und unbelichteten Stellen klebrig, so daß die Vorlage nicht ohne Beschädigung der Schicht wieder abgetrennt werden konnte.

## Patentansprüche

1. Photopolymerisierbares Kopiermaterial mit einem Schichtträger und einer photopolymerisierbaren Kopierschicht mit freiliegender Oberfläche, die ein polymeres Bindemittel, eine Verbindung mit mindestens zwei endständigen äthylenisch ungesättigten radikalisch polymerisierbaren Gruppen, einen Photoinitiator zur Einleitung der radikalischen Polymerisation und ein feinteiliges Pigment enthält, dadurch gekennzeichnet, daß die mittlere Teilchengröße des Pigments mindestens der Schichtdicke der Kopierschicht entspricht.

2. Kopiermaterial nach Anspruch 1, dadurch gekennzeichnet, daß die Kopierschicht 0,5 bis 12 µm dick ist.

3. Kopiermaterial nach Anspruch 1, dadurch gekennzeichnet, daß die mittlere Teilchengröße des Pigments zwischen 2 und 30 µm liegt.

4. Kopiermaterial nach Anspruch 1, dadurch gekennzeichnet, daß die Kopierschicht 0,05 bis 5 Gew.-%, bezogen auf die nichtflüchtigen Bestandteile der Schicht, an feinteiligem Pigment enthält.

5. Kopiermaterial nach Anspruch 1, dadurch gekennzeichnet, daß das feinteilige Pigment aus Kieselsäure, Aluminiumoxid, Aluminiumsilikat, Aluminiumhydroxid oder Titandioxid besteht.

6. Kopiermaterial nach Anspruch 1, dadurch gekennzeichnet, daß das polymere Bindemittel in verdünnter
wäßrig-alkalischer Lösung löslich ist.

7. Kopiermaterial nach Anspruch 1, dadurch gekennzeichnet, daß der Schichtträger eine Aluminiumfolie
mit anodisch erzeugter Oxidschicht ist.

8. Verfahren zur Herstellung von Reliefbildern, bei
dem man ein photopolymerisierbares Kopiermaterial mit
einem Schichtträger und einer photopolymerisierbaren
Kopierschicht mit freiliegender Oberfläche, die ein
polymeres Bindemittel, eine Verbindung mit mindestens
zwei endständigen äthylenisch ungesättigten radikalisch
polymerisierbaren Gruppen, einen Photoinitiator zur
Einleitung der radikalischen Polymerisation und ein
feinteiliges Pigment enthält, im unmittelbaren Kontakt
der freiliegenden Schichtoberfläche mit einer transparenten Vorlage und unter Vakuum belichtet und die unbelichteten Bereiche der Kopierschicht mit einem Entwickler auswäscht, dadurch gekennzeichnet, daß man
ein feinteiliges Pigment verwendet, dessen mittlere
Teilchengröße mindestens der Schichtdicke der Kopierschicht entspricht.